# FASCICULE DE BREVET EUROPEEN

(11) **EP 2 926 443 B1**
(45) Date de publication et mention de la délivrance du brevet: **15.04.2020**
(21) Numéro de dépôt: 13803185.1
(22) Date de dépôt: 26.11.2013
(51) Int. Cl.: H02M 1/08, H03K 17/567, H03K 17/10, H02M 3/335, H02M 3/155, H02M 1/00

(54) **CONVERTISSEUR DE TENSION CONTINU-CONTINU À HAUTE TENSION AVEC TRANSISTOR JFET**
DC/DC WANDLER FÜR HOHE SPANNUNGEN MIT JFET SCHALTELEMENT
DC-DC HIGH VOLTAGE CONVERTER WITH JFET SWITCH

(30) Priorité: 27.11.2012 FR 1261313
(43) Date de publication de la demande: 07.10.2015
(73) Titulaire: Safran Electrical & Power, 31702 Blagnac Cedex (FR); Centre National de la Recherche Scientifique (C.N.R.S.), 75016 Paris (FR)
(72) Inventeur: DUBOIS, Fabien, F-95880 Enghien Les Bains (FR); BERGOGNE, Dominique, F-43140 Saint-Didier-en-Velay (FR)
(74) Mandataire: Brevalex
(86) Numéro de dépôt international: PCT/FR2013/052862
(87) Numéro de publication internationale: WO 2014/083274

(56) Documents cités:
- WO-A2-03/009455
- DE-A1-102006 017 242
- DE-U1- 20 109 957

## Description

### DOMAINE TECHNIQUE

La présente invention concerne un convertisseur de tension continu-continu destiné à être alimenté à partir d'une source de tension continue ayant une grande dynamique de tension.

### ÉTAT DE LA TECHNIQUE ANTÉRIEURE

Dans les applications aéronautiques notamment, la source de tension continue est un bus HVDC et la tension peut prendre des valeurs comprises entre 650 V et 750 V en régime permanent, par exemple. Mais le démarrage se fait sous faible tension de l'ordre de quelques volts à la dizaine de volts. Les exigences de sécurité imposent que le dispositif utilisateur de la tension continue ne présente pas de dysfonctionnement à la mise sous tension, à l'extinction ou même pendant des périodes de transitoires de tension.

Le dispositif utilisateur relié à la source de tension peut être un onduleur. Pour des hautes tensions et pour des fonctionnements à haute température de l'ordre de 200°C, on a été amené à utiliser, dans cet onduleur des composants interrupteurs en carbure de silicium comme des transistors JFET qui sont des composants normalement passants, c'est-à-dire qu'ils sont conducteurs en l'absence de tension de polarisation.

Bien souvent, l'interrupteur JFET de l'onduleur est relié à un circuit de démarrage monté en série entre la tension d'alimentation et sa grille comme décrit dans la demande de brevet FR 2 937 811, le circuit de démarrage a deux étages et inclut un régulateur linéaire abaisseur et un inverseur de tension, ce montage étant utilisé dans un but de protection de l'interrupteur JFET normalement passant lors de la perte des tensions de commande de l'interrupteur.

Un inconvénient de cette solution est qu'elle est dissipative pouvant engendrer des problèmes thermiques par dissipation de puissance au niveau du régulateur abaisseur. Cela devient critique pour des températures élevées.

Dans un autre circuit de démarrage à un seul étage comprenant un convertisseur qui transforme une tension continue en une autre tension continue négative, avec une diode Zener en série avec une résistance, la dissipation de puissance est moindre si la résistance a une très forte valeur. Par exemple pour une tension de bus de 750 V et une puissance dissipée dans la diode Zener de 50 mW à 200°c, la résistance série est de 76 kΩ.

Pour des fonctionnements avec une tension de bus réduite par rapport à la valeur nominale, par exemple de l'ordre de la centaine de Volts, la résistance élevée ne permet plus de polariser la diode Zener. Dans ce cas, la tension minimale de démarrage est supérieure à celle obtenue avec le régulateur abaisseur et l'inverseur de tension.

De plus, le temps de réponse du circuit de démarrage est augmenté, puisque la constante de temps formée par la résistance série et un condensateur de découplage inévitable est grande, de l'ordre de la dizaine de millisecondes. Dans la pratique, il serait souhaitable que ce temps de réponse soit très faible, par exemple inférieur à la centaine de microsecondes.

Les documents WO03009455 et DE20109957 décrivent chacun un convertisseur de tension comprenant un transformateur avec un enroulement primaire en série avec un commutateur comprenant un semi-conducteur.

### EXPOSÉ DE L'INVENTION

La présente invention a pour but de proposer un convertisseur de tension continu-continu qui peut servir à la commande de transistors JFET, notamment dans des onduleurs, ne présentant pas les limitations et difficultés ci-dessus. La présente invention est définie dans la revendication indépendante 1.

Un but de l'invention est de proposer un convertisseur de tension continu-continu qui supporte d'être alimenté par une source de tension ayant une très grande dynamique en tension. La très grande dynamique en tension signifie que le rapport entre la tension minimale appliquée à son entrée pour qu'il délivre une tension de sortie souhaitée et la tension maximale d'entrée qu'il peut supporter sans détérioration est supérieure à deux, par exemple 100.

De plus, le convertisseur de tension continu-continu dissipe peu de chaleur, ce qui évite les problèmes thermiques évoqués plus haut.

Un autre but de l'invention est de fournir un convertisseur de tension continu-continu qui soit capable de délivrer une tension de sortie à un circuit utilisateur à partir d'une tension continue amenée à varier entre quelques volts et plusieurs centaines de volts voire un ou plusieurs kilovolts, par exemple lors de transitoires de mise sous tension, de démarrages...

Un autre but de l'invention est de proposer un convertisseur de tension continu-continu qui soit capable de fonctionner à haute température de l'ordre d'au moins 200°C.

Encore un autre but de l'invention est de proposer un convertisseur de tension continu-continu qui permette de protéger des composants semi-conducteurs interrupteurs normalement passants, notamment dans des onduleurs de puissance directement reliés à une source de tension ou un bus de redistribution.

Pour y parvenir, la présente invention consiste à utiliser un interrupteur principal formé d'un élément interrupteur normalement passant et d'un élément interrupteur normalement bloqué montés en série et un circuit détecteur de crêtes principal.

Plus précisément, la présente invention concerne un convertisseur de tension continu-continu comportant un interrupteur principal formé d'un élément interrupteur normalement passant monté en série avec un élément interrupteur normalement bloqué équipé d'un circuit de commande. Un premier nœud est commun aux deux éléments interrupteurs. Une charge est montée en série avec l'interrupteur principal, l'interrupteur principal et la charge étant destinés à être montés aux bornes d'une source de tension continue. Un circuit détecteur de crêtes principal est relié en entrée à l'interrupteur principal et en sortie au circuit de commande de l'élément interrupteur normalement bloqué.

Le circuit détecteur de crêtes principal comporte avantageusement un interrupteur unidirectionnel en courant en série avec un réservoir d'énergie électrique, l'interrupteur unidirectionnel en courant est monté entre le premier nœud et le réservoir d'énergie électrique. Il est destiné, lorsqu'il est fermé, à charger le réservoir d'énergie électrique, le réservoir d'énergie électrique délivrant une tension utile principale lorsque l'interrupteur unidirectionnel en courant est ouvert, la tension utile principale étant prélevée à un second nœud entre le réservoir d'énergie électrique et l'interrupteur unidirectionnel en courant, ce second nœud étant relié au circuit de commande de l'élément interrupteur normalement bloqué.

L'interrupteur unidirectionnel en courant peut être une diode ou un transistor ou un agencement de plusieurs transistors en série ou en parallèle. L'interrupteur unidirectionnel en courant est relié au premier nœud commun entre l'élément interrupteur normalement passant et l'élément interrupteur normalement bloqué formant l'interrupteur principal.

Le réservoir d'énergie électrique peut être un condensateur ou une batterie ou un supercondensateur.

L'élément interrupteur normalement passant est destiné à être relié à une des bornes de la source de tension via la charge, l'élément interrupteur normalement bloqué étant destiné à être relié à l'autre borne de la source de tension, les deux éléments interrupteurs ayant un nœud commun.

Dans un mode de réalisation, le circuit détecteur de crêtes principal peut être monté en parallèle avec l'élément interrupteur normalement bloqué.

L'élément interrupteur normalement passant peut être un transistor à enrichissement tel un JFET en carbure de silicium, un transistor normalement bloqué commandé de manière à fonctionner comme un transistor normalement passant, un limiteur de courant possédant une entrée inhibition pilotée par une tension auxiliaire telle que la tension de sortie ou la tension aux bornes de l'élément interrupteur normalement bloqué.

L'élément interrupteur normalement bloqué peut être un MOSFET, un IGBT, un transistor bipolaire à jonction, par exemple en carbure de silicium ou tout autre type d'interrupteur à semi-conducteur ou pas.

La charge peut être résistive ou inductive.

La tension utile principale peut être la tension de sortie du convertisseur de tension continu-continu.

Dans un mode de réalisation permettant d'obtenir une tension de sortie isolée de la source de tension continue, la charge est un transformateur avec un enroulement primaire et au moins un enroulement secondaire.

Dans ce mode de réalisation, le circuit détecteur de crêtes principal peut comporter, en outre, un interrupteur unidirectionnel en courant supplémentaire relié d'une part au nœud entre le réservoir d'énergie électrique et l'interrupteur unidirectionnel en courant et d'autre part à l'enroulement secondaire du transformateur

Le transformateur peut comporter au moins un enroulement secondaire aux bornes duquel un circuit de redressement est branché, une tension de sortie étant prélevée aux bornes du circuit de redressement.

Il est possible de prévoir que l'élément interrupteur normalement passant soit équipé d'un circuit de commande relié en sortie du circuit détecteur de crêtes principal, ou à une extrémité de l'interrupteur principal à relier à la source de tension continue, ou encore, lorsque la charge est un transformateur qui comporte au moins un enroulement secondaire aux bornes duquel un circuit de redressement est branché et que ce circuit de redressement comporte un réservoir d'énergie électrique, à un nœud entre l'enroulement secondaire et le réservoir d'énergie électrique du circuit de redressement.

Dans un autre mode de réalisation, l'élément interrupteur normalement passant peut avoir une borne de commande reliée à la seconde extrémité de l'interrupteur principal.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
La figure 1 est un schéma d'un exemple d'un premier mode de réalisation du convertisseur de tension continu-continu objet de l'invention ;
Les figures 2A à 2E illustrent, respectivement, l'évolution dans le temps, de la tension de la source de tension dès son démarrage, de la tension de commande de l'élément interrupteur normalement bloqué, de la tension de commutation de l'élément interrupteur normalement bloqué, de la tension de commutation de l'élément interrupteur normalement passant et de la tension de commande de l'élément interrupteur normalement passant ;
La figure 3 représente un exemple d'un autre mode de réalisation du convertisseur de tension continu-continu objet de l'invention ;
La figure 4 illustre un exemple d'un autre mode de réalisation du convertisseur de tension continu-continu objet de l'invention ;
La figure 5 illustre encore un exemple d'un mode de réalisation du convertisseur de tension continu-continu objet de l'invention.

Les différents modes de réalisation du convertisseur de tension continu doivent être compris comme n'étant pas forcément exclusifs les uns des autres.

### EXPOSÉ DÉTAILLÉ DE MODES DE RÉALISATION PARTICULIERS

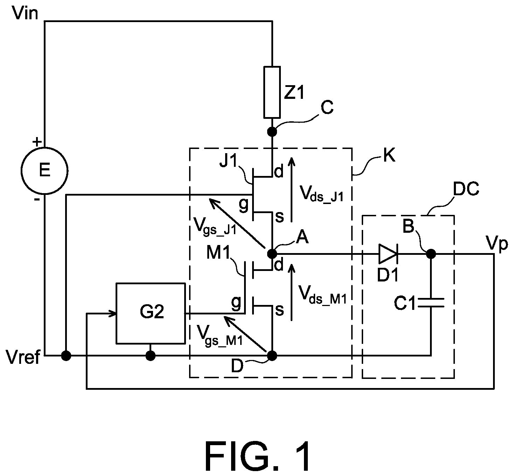

La figure 1 illustre un premier exemple du convertisseur de tension continu-continu objet de l'invention. Ce convertisseur de tension continu-continu est dévolteur.

Ce convertisseur comporte un interrupteur principal K ayant deux bornes extrêmes C et D destinées à être reliées à une source de tension continue E, la liaison de la première borne C se faisant via une charge Z1 au travers de laquelle s'écoule un courant électrique provenant de la source de tension continue E. La source de tension continue E comporte une borne positive + à relier à la charge Z1 et une borne négative - à relier à la seconde borne D de l'interrupteur principal K. La borne positive est portée à la tension Vin et la borne négative est portée à une tension de référence Vref.

L'interrupteur principal K comporte deux éléments interrupteurs J1, Ml montés en série de nature différente. Ils sont reliés entre eux au niveau d'un nœud A.

L'élément interrupteur J1 est un interrupteur normalement passant tandis que l'élément interrupteur Ml est un interrupteur normalement bloqué. L'élément interrupteur normalement passant J1 est destiné à être relié à la borne positive de la source de tension E via la charge Z1, l'élément interrupteur normalement bloqué Ml est destiné à être relié à la borne négative de la source de tension E.

L'élément interrupteur normalement bloqué Ml dispose d'un circuit de commande G2 pour commander son état bloqué ou passant. L'élément interrupteur normalement passant J1 peut être pourvu aussi de son propre circuit de commande G1.

L'élément interrupteur J1 normalement passant est un interrupteur haute tension. L'élément interrupteur Ml normalement bloqué peut être un interrupteur basse tension.

Par élément interrupteur haute tension et élément interrupteur basse tension, on veut dire que l'élément interrupteur haute tension supporte des tensions plus importantes que l'élément interrupteur basse tension.

Dans l'application où la source de tension continue est un bus HVDC, l'élément interrupteur haute tension J1 supporte quasiment la tension du bus HVDC alors que l'élément interrupteur Ml basse tension ne supporte que quelques dizaines de volts.

L'élément interrupteur J1 normalement passant peut être réalisé par un transistor à enrichissement, par exemple un JFET en carbure de silicium ayant classiquement un drain d, une source s et une grille g. Un tel transistor a sa tension de commutation entre son drain et sa source Vds_J1 sensiblement nulle lorsque sa tension de commande entre sa grille et sa source Vgs_J1 est sensiblement nulle. Un tel élément interrupteur de type JFET présente l'avantage de commuter très rapidement, de générer moins de pertes en conduction à l'état passant que d'autres interrupteurs électroniques de puissance commandés en tension, d'avoir une meilleure tenue en température et en tension, et une résistance spécifique plus faible que ces interrupteurs électroniques de puissance commandés en tension. La source s est reliée à la borne positive de l'alimentation électrique E via la charge Z1, le drain d est relié à l'élément interrupteur normalement bloqué Ml et sa grille g est reliée dans ce premier exemple, à la seconde borne D de l'interrupteur principal K. Il est envisageable que l'élément interrupteur normalement passant J1 soit équipé de son propre circuit de commande G1 comme on le verra ultérieurement.

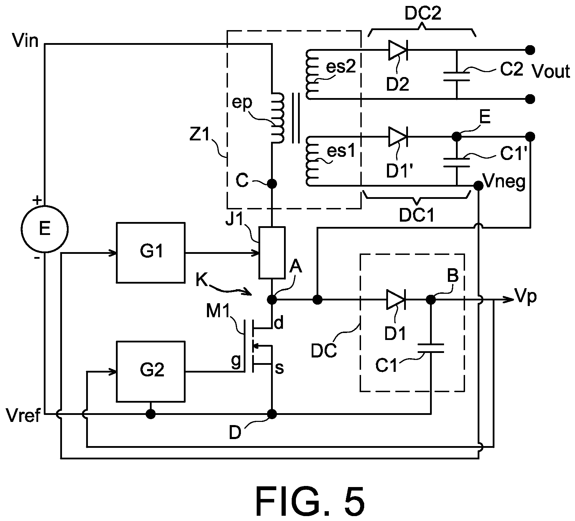

En variante, l'élément interrupteur J1 normalement passant pourrait être réalisé par un transistor normalement bloqué commandé de manière à fonctionner comme un interrupteur normalement passant. L'élément interrupteur normalement passant J1 pourrait aussi être réalisé par un limiteur de courant comme décrit à la figure 5.

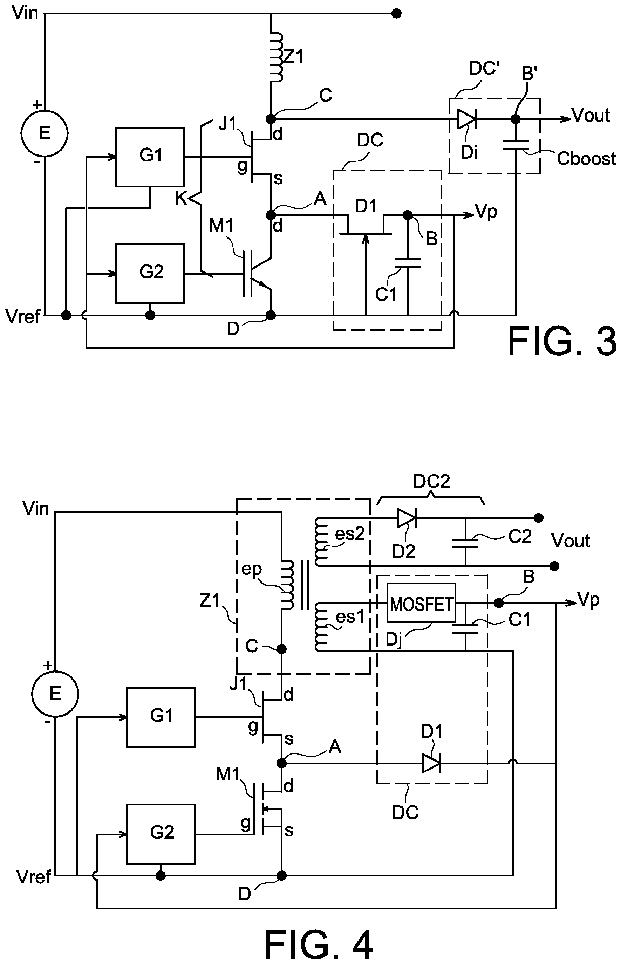

L'élément interrupteur normalement bloqué Ml peut être réalisé par un transistor MOSFET, par exemple en silicium ou en silicium sur isolant SOI. Il possède classiquement un drain d relié à l'élément interrupteur normalement passant J1, une source s reliée à la borne négative de la source de tension continue E et une grille g reliée à son circuit de commande G2. En variante, il pourrait être réalisé par un transistor bipolaire à jonction BJT, par exemple en carbure de silicium, comme illustré sur la figure 3, par un IGBT ou par tout autre type d'interrupteur à semi-conducteur ou pas, commandé de manière appropriée.

Le convertisseur de tension continu-continu comporte, en outre, un circuit détecteur de crêtes principal DC formé d'un interrupteur unidirectionnel en courant D1 et d'un réservoir d'énergie électrique C1 montés en série.

Le circuit détecteur de crêtes principal DC est monté en parallèle avec l'élément interrupteur normalement bloqué Ml.

Le circuit détecteur de crêtes principal DC est donc relié à la seconde borne D de l'interrupteur principal K et au nœud commun A commun aux deux éléments interrupteurs J1, Ml de l'interrupteur principal K.

L'interrupteur unidirectionnel en courant D1 est monté entre le nœud A et le réservoir d'énergie électrique C1. L'interrupteur unidirectionnel en courant D1 peut être réalisé par une diode ou par un plusieurs transistors, ces transistors étant agencés en série ou en parallèle lorsqu'il y en a plusieurs. Sur la figure 3, il s'agit d'un transistor JFET. Le drain du transistor JFET est relié au nœud A, sa grille à la seconde borne D de l'interrupteur principal K et sa source au réservoir d'énergie C1. En variante, l'interrupteur unidirectionnel en courant D1 du circuit détecteur de crêtes pourrait être formé d'un transistor bipolaire à jonction BJT, d'un transistor MOSFET ou de plusieurs transistors MOSFET montés en série ou en parallèle ou encore de tout autre type de transistors.

Dans l'exemple de la figure 1, le réservoir d'énergie électrique C1 est monté entre l'interrupteur unidirectionnel en courant D1 et la seconde borne D de l'interrupteur principal K. Le nœud commun entre l'interrupteur unidirectionnel en courant D1 et le réservoir d'énergie électrique C1, appelé B, est relié en entrée du circuit de commande G2 de l'élément interrupteur normalement bloqué Ml. Dans cet exemple, la sortie du convertisseur de tension continu-continu se fait au niveau de ce nœud commun B. On a appelé tension utile principale Vp la tension continue délivrée par le circuit détecteur de crêtes principal DC, elle est fournie au niveau du nœud commun B.

Le réservoir d'énergie électrique C1 est destiné à stocker de l'énergie électrique lorsque l'interrupteur unidirectionnel en courant D1 est fermé et à fournir cette énergie sous la forme de la tension utile principale Vp, lorsque l'interrupteur unidirectionnel en courant D1 est ouvert. Le réservoir d'énergie électrique C1 peut être réalisé par un condensateur, une batterie ou un supercondensateur.

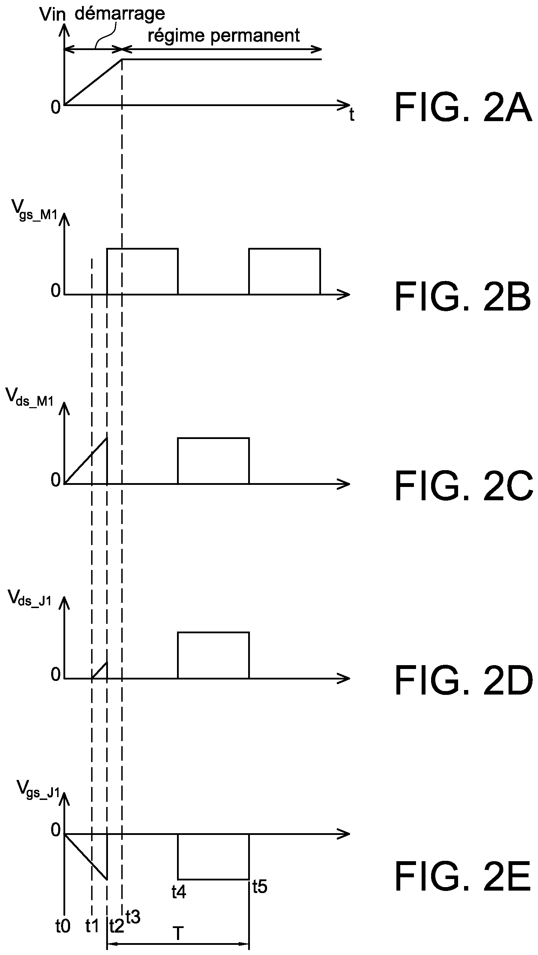

Les figures 2A à 2E présentent les allures des formes d'ondes à différents niveaux du convertisseur de tension continu-continu objet de l'invention, ce convertisseur étant conforme à celui de la figure 1 avec pour élément interrupteur normalement passant J1 : un transistor JFET et pour élément interrupteur normalement bloqué Ml : un transistor MOSFET.

Sur la figure 2A est représentée l'évolution dans le temps de la tension d'entrée Vin du convertisseur de tension continu-continu objet de l'invention. C'est la tension délivrée par la source de tension continue E. Dans les applications aéronautiques, ce sera la tension fournie par un bus continu à haute tension HVDC. Lors de la mise en route de la source de tension, la tension croît pendant une phase de démarrage jusqu'à atteindre, en régime permanent, une valeur constante.

Sur la figure 2B est représentée l'allure, dans le temps, de la tension de commande grille-source Vgs_Ml de l'élément interrupteur normalement bloqué Ml.

Sur la figure 2C est représentée l'allure, dans le temps, de la tension commutée entre le drain et la source Vds_Ml de l'élément interrupteur normalement bloqué Ml.

Sur la figure 2D est représentée l'allure, dans le temps, de la tension commutée entre le drain et la source Vds_J1 de l'élément interrupteur normalement passant J1.

Sur la figure 2E est représentée l'allure, dans le temps, de la tension de commande grille-source Vgs_J1 de l'élément interrupteur normalement passant J1.

Au démarrage de la source de tension E, à l'instant t0, la tension Vin croît linéairement jusqu'à attendre un plafond, en régime permanent, à l'instant t3.

L'élément interrupteur normalement passant J1 est passant, la tension commutée entre son drain et sa source Vds_J1 est constante et nulle.

L'élément interrupteur normalement bloqué Ml est bloqué, la tension commutée entre son drain et sa source Vds_Ml croît de la même façon que la tension Vin et l'interrupteur unidirectionnel en courant D1 conduit, ce qui fait que le réservoir d'énergie électrique C1 se remplit à la tension Vds_M1. La tension utile principale Vp, délivrée par le circuit détecteur de crêtes principal, alimentant le circuit de commande G2 de l'élément interrupteur normalement bloqué Ml augmente. Puisque la source de l'élément interrupteur normalement passant J1 est connectée au drain du transistor normalement bloqué Ml au nœud A, la tension de commande grille-source Vgs_J1 de l'élément interrupteur normalement passant J1 croît négativement, ce qui a pour effet, à un instant t1 suivant l'instant t0, de bloquer l'élément interrupteur normalement passant J1. Cet instant t1 est antérieur à l'instant t3 de passage en régime permanent de la source de tension E. La tension commutée entre son drain et sa source Vds_J1 commence comme à croître de la même façon que la tension Vin mais avec un retard par rapport au démarrage de la source de tension E.

Une application de la tension utile principale Vp au circuit de commande G2 suffisante, par exemple de l'ordre de quelques volts, par exemple 2 à 4 V, fait que l'élément interrupteur normalement bloqué Ml commute à l'état passant grâce à l'intervention du circuit de commande G2 à un instant t2 suivant l'instant t1 mais antérieur à l'instant t3.

A cet instant t2, la tension commutée entre le drain et la source Vds_Ml de l'élément interrupteur normalement bloqué Ml s'annule, l'interrupteur unidirectionnel en courant D1 s'ouvre et l'élément interrupteur normalement passant J1 redevient passant. Le circuit détecteur de crêtes principal DC fournit au circuit de commande G2 de l'élément interrupteur normalement bloqué Ml une tension utile principale Vp nécessaire pour le maintenir passant.

Le réservoir d'énergie électrique C1 se vide, mais pas complètement, la variation de la tension à ses bornes dépend de la charge à fournir au circuit de commande G2. La tension de commande grille-source Vgs_Ml de l'élément interrupteur normalement bloqué Ml s'annule et l'élément interrupteur normalement bloqué Ml redevient bloqué à un instant t4 qui suit l'instant t3. En même temps, l'élément interrupteur normalement passant J1 se bloque. La tension de commutation drain-source Vds_Ml de l'élément interrupteur normalement bloqué Ml recommence à augmenter. Il en est de même pour la tension de commutation drain-source Vds_J1 de l'élément interrupteur normalement passant J1.

A cet instant t4, l'interrupteur unidirectionnel en courant D1 se ferme et le réservoir d'énergie électrique C1 se charge à la tension de commutation drain-source Vds_M1.

L'élément interrupteur normalement bloqué Ml est donc passant entre les instants t2 et t4 puis bloqué entre les instants t4 et t5. Ce phénomène cyclique se reproduit à chaque période T de découpage du convertisseur de tension continu-continu.

La tension utile principale Vp produite par le convertisseur de tension continu-continu aux bornes du réservoir d'énergie électrique C1 est égale à la tension de pincement de l'élément interrupteur normalement passant J1.

La valeur moyenne de la tension aux bornes de la charge Z1 est égale à la tension Vin multipliée par le rapport cyclique α du convertisseur, c'est-à-dire le rapport entre la durée de mise en conduction de l'élément interrupteur normalement bloqué Ml et la période de découpage T du convertisseur de tension continu-continu. La tension aux bornes de la charge Z1 est une tension en créneau variant entre Vref et la valeur de la tension Vin en régime permanent.

Le convertisseur de tension continu-continu objet de l'invention démarre donc pour une tension de la source de tension E très faible, de l'ordre de quelques volts, alors que la source de tension E possède une dynamique en tension de l'ordre de plusieurs centaines de volts voire plus.

Cette tension de démarrage du convertisseur de tension continu-continu correspond au seuil de mise en conduction de l'élément interrupteur normalement bloqué Ml et au seuil de réveil du circuit de commande G2 de l'élément interrupteur normalement bloqué Ml. Néanmoins, un des aspects importants de l'invention est de pouvoir obtenir une tension aux bornes du réservoir d'énergie électrique C1 dès que la tension d'entrée Vin n'est plus nulle, c'est à dire dès l'instant où, lors de la mise sous tension, la tension du bus continu, E, commence à croitre à partir de zéro. Si l'interrupteur unidirectionnel en courant D1 est un dispositif de redressement sans seuil, à transistor normalement passant par exemple comme à la figure 3, le réservoir d'énergie électrique C1 se charge exactement dès que la tension E est différente de zéro.

Le convertisseur de tension continu-continu objet de l'invention peut être utilisé par exemple pour alimenter les circuits de commande des composants électroniques normalement passants d'un onduleur, mais ce n'est pas une obligation. Plus généralement, il peut alimenter des circuits de commande, des circuits de protection ou tout circuit alimenté par un réseau d'alimentation continu.

Ce convertisseur convient pour des applications à haute température car les deux éléments interrupteurs J1, Ml qu'il comporte ont une version haute température, l'interrupteur unidirectionnel en courant D1 également, en ce qui concerne le réservoir d'énergie électrique C1, il peut s'agir d'un condensateur en céramique NP0.

Dans l'exemple illustré à la figure 1, la charge Z1 peut représenter des éléments parasites. Il est possible qu'elle soit une inductance comme illustré sur la figure 3. Le convertisseur de tension continu-continu représenté est alors qualifié de survolteur (boost en anglais) ou encore de hacheur parallèle et plus de dévolteur. Dans ce cas, la charge Z1 est une inductance de stockage reliée à l'interrupteur principal K au niveau de sa première borne C. Un circuit de redressement DC' est monté en parallèle avec l'interrupteur principal K. Il comporte un interrupteur unidirectionnel en courant Di monté en série avec un réservoir d'énergie électrique Cboost. Le circuit de redressement DC' est relié, côté interrupteur unidirectionnel en courant Di, à la première borne C de l'interrupteur principal K et côté réservoir d'énergie électrique Cboost à la seconde borne D de l'interrupteur principal K. L'interrupteur unidirectionnel en courant Di et le réservoir d'énergie électrique Cboost ont un nœud commun appelé B'et une tension de sortie Vout plus élevée que Vin est disponible au nœud B'.

L'inductance pourrait être une inductance de fuite d'un transformateur d'alimentation à découpage par exemple. L'élément interrupteur normalement passant J1 dissipera l'énergie stockée dans l'inductance Z1 si c'est un transistor JFET et que sa grille est portée à la tension de référence Vref comme montré sur la figure 1. L'élément interrupteur normalement passant J1 pourra fonctionner en avalanche car la branche avec l'inductance Z1 et l'interrupteur principal K est ouverte par les éléments interrupteurs J1 et Ml.

Toutefois, ce n'est pas cette configuration qui est illustrée sur la figure 3. L'élément interrupteur normalement passant J1 est relié à son propre circuit de commande G1 et ce dernier est alimenté par la tension utile principale Vp délivrée par le circuit détecteur de crêtes principal DC. Ainsi, la tension de commande grille-source de l'élément interrupteur normalement passant J1 est supérieure à sa tension de seuil.

Le réservoir d'énergie électrique C1 se chargera alors à partir de l'énergie stockée par l'inductance Z1, lorsque l'élément interrupteur normalement passant J1 est passant et l'élément interrupteur normalement bloqué Ml bloqué.

L'interrupteur unidirectionnel en courant D1 pourra être réalisé par au moins un transistor MOSFET, utilisé par exemple en redressement synchrone. Le circuit de commande G2 de l'élément interrupteur normalement bloqué Ml pourra alors intégrer un générateur de signaux à largeur d'impulsions variable. Le circuit de commande G1 de l'élément interrupteur normalement passant J1 pourra intégrer un inverseur de tension si on souhaite bloquer l'élément interrupteur normalement passant J1.

La figure 4 illustre un autre exemple de convertisseur de tension continu-continu objet de l'invention. Maintenant la charge Z1 est un transformateur et ce dernier comporte classiquement un enroulement primaire ep monté entre la borne positive de la source de tension continue E et le nœud C. Il comporte également au moins un enroulement secondaire esl. Le circuit détecteur de crêtes principal DC comporte l'élément interrupteur unidirectionnel en courant D1 en série avec le réservoir d'énergie électrique C1, il est connecté comme dans les deux exemples précédents illustrés aux figures 1 et 3. Mais circuit détecteur de crêtes principal DC comporte en outre un interrupteur unidirectionnel en courant supplémentaire Dj relié d'une part au nœud B entre le réservoir d'énergie électrique C1 et l'interrupteur unidirectionnel en courant D1 et d'autre part à une première extrémité d'un enroulement secondaire esl du transformateur Z1. L'autre extrémité de l'enroulement secondaire esl est reliée à la seconde borne D de l'interrupteur principal K. L'interrupteur unidirectionnel en courant supplémentaire Dj peut être de même nature que l'interrupteur unidirectionnel en courant D1. L'interrupteur unidirectionnel en courant D1 assure le démarrage du circuit de commande G2 de l'élément interrupteur normalement bloqué Ml, la tension Vin étant encore faible et augmentant. Ensuite, l'interrupteur unidirectionnel en courant D1 se bloque et l'enroulement secondaire esl, l'interrupteur unidirectionnel en courant supplémentaire Dj assurent alors l'alimentation du circuit de commande G2 de l'élément interrupteur normalement bloqué Ml.

Le circuit de commande G1 de l'élément interrupteur normalement passant J1 est relié à la tension Vref, c'est-à-dire à la seconde borne D de l'interrupteur principal K à relier à la source de tension continue E.

Ce montage permet d'augmenter le rendement en utilisant un système à découpage et le démarrage se fait pour des tensions plus petites que dans les exemples précédents. Il permet un démarrage du convertisseur pour une tension d'entrée très faible.

Si l'élément interrupteur J1 est un transistor JFET, il ne fonctionnera jamais en zone linéaire et la dissipation de puissance sera réduite.

Sur l'exemple de la figure 4, le transformateur Z1 comporte, en outre, un enroulement secondaire supplémentaire es2. Un circuit de redressement DC2 est branché aux bornes de l'enroulement secondaire supplémentaire es2. Ce circuit de redressement DC2 délivre une tension de sortie continue Vout qui est isolée de manière galvanique de la source de tension E.

Le circuit de redressement DC2 peut être de même nature que le circuit détecteur de crêtes principal DC des exemples décrits aux figures 1 et 3. Le circuit de redressement DC2 est formé d'un interrupteur unidirectionnel en courant D2, d'un réservoir d'énergie électrique C2 montés en série. On aurait pu prévoir d'autres enroulements secondaires supplémentaires et plusieurs autres circuits de redressement si on veut bénéficier de plusieurs autres tensions de sortie continues isolées de manière galvanique de la source de tension E.

Par souci de simplification, on a donné le même nom au potentiel Vp et à la tension utile principale Vp, ce qui suppose que Vref est nul. Il est bien sûr que Vref peut ne pas être nul, mais cela ne pose aucun problème de compréhension à l'homme du métier.

Le circuit représenté sur la figure 4 conduit à un démarrage du convertisseur de tension continu-continu sous plus faible tension Vin.

La figure 5 illustre encore un autre exemple du convertisseur continu-continu objet de l'invention. Sur cette figure 5, la charge est toujours un transformateur avec deux éléments secondaires esl, es2. Chacun d'entre eux est relié à un circuit de redressement DC1, DC2. Dans cet exemple, ces circuits de redressement DC1, DC2 sont similaires à celui appelé DC2 sur la figure 4. L'interrupteur unidirectionnel en courant du circuit de redressement DC1 est nommé Dl' et le réservoir d'énergie électrique est nommé Cl'.

Le nœud commun entre l'interrupteur unidirectionnel en courant Dl' et le réservoir d'énergie électrique Cl' du circuit de redressement DC1 est appelé E, il est relié au nœud commun A entre l'élément interrupteur normalement passant J1 et l'élément interrupteur normalement bloqué M1 de l'interrupteur principal K. Le réservoir d'énergie électrique Cl' a une de ses bornes reliée au nœud E et l'autre reliée en entrée du circuit de commande G1 de l'élément interrupteur normalement passant J1. Cette autre borne est portée à un potentiel Vneg qui est négatif par rapport au potentiel présent au nœud A commun entre l'élément interrupteur normalement passant J1 et l'élément interrupteur normalement bloqué Ml.

Dans cet exemple, le circuit détecteur de crêtes principal DC est similaire à celui illustré sur les figures 1 et 3. La sortie du circuit détecteur de crêtes principal DC alimente le circuit de commande G2 de l'élément interrupteur normalement bloqué Ml. La tension Vp est positive par rapport à Vref.

De plus, l'élément interrupteur normalement passant J1 est un limiteur de courant possédant une entrée inhibition pilotée par Vneg.

Comme décrit à la figure 4, le circuit de redressement DC2 délivre une tension de sortie continue Vout qui est isolée de manière galvanique de la source de tension E. Cette tension Vout peut alimenter un circuit extérieur (non représenté), par exemple un circuit de commande de grille d'un transistor JFET de puissance.

Le convertisseur de tension continu-continu de l'invention a pour principal avantage d'avoir un fonctionnement linéaire pour des très faibles tensions de la source de tension et un fonctionnement par découpage pour les tensions élevées. Cela conduit à une réduction de la consommation électrique et donc à une dissipation thermique réduite.

Un autre avantage du convertisseur de tension continu-continu est qu'il comporte moins de composants passifs haute tension que n'en a le circuit de démarrage décrit dans la demande de brevet citée plus haut.

Il est bien entendu que certaines caractéristiques représentées sur ces exemples de modes de réalisation du convertisseur de tension continu-continu peuvent être combinées entre elles sans sortir du cadre de l'invention.

## Revendications

1. Convertisseur de tension continu-continu comportant un interrupteur principal (K) formé d'un élément interrupteur, normalement passant (J1) monté en série avec un élément interrupteur normalement bloqué (M1) équipé d'un circuit de commande (G2), un premier nœud (A) étant commun aux deux éléments interrupteurs (J1, M1), une charge (Z1) de type transformateur avec un enroulement primaire (ep) et au moins un enroulement secondaire (es1, es2), l'enroulement primaire (ep) étant en série avec l'interrupteur principal (K), l'interrupteur principal et l'enroulement primaire (ep) étant destinés à être montés aux bornes d'une source de tension continue (E), un circuit détecteur de crêtes principal (DC) relié en entrée à l'interrupteur principal et en sortie au circuit de commande (G2) de l'élément interrupteur normalement bloqué (M1), dans lequel le circuit détecteur de crêtes principal (DC) comporte un interrupteur unidirectionnel en courant (D1) en série avec un réservoir d'énergie électrique (C1), l'interrupteur unidirectionnel en courant étant monté entre le premier nœud (A) et le réservoir d'énergie électrique (C), l'interrupteur unidirectionnel en courant (D1) étant destiné, lorsqu'il est fermé, à charger le réservoir d'énergie électrique (C1), le réservoir d'énergie électrique (C1) délivrant une tension utile principale (Vp) lorsque l'interrupteur unidirectionnel en courant est ouvert (D1), la tension utile principale (Vp) étant prélevée à un second nœud (B) entre le réservoir d'énergie électrique (C1) et l'interrupteur unidirectionnel en courant (D1), **caractérisé en ce que** ce second nœud (B) est relié en entrée du circuit de commande (G2) de l'élément interrupteur normalement bloqué (M1) et **en ce que** le circuit détecteur de crêtes principal (DC) comporte en outre un interrupteur unidirectionnel en courant supplémentaire (Dj) relié d'une part au second nœud (B) et d'autre part à l'enroulement secondaire (es1),
dans lequel l'élément interrupteur normalement passant (J1) est équipé d'un circuit de commande (G1) relié à une extrémité de l'interrupteur principal (K) à relier à la source de tension continue (E).

2. Convertisseur de tension continu-continu selon la revendication 1, dans lequel le dispositif unidirectionnel en courant (D1) est une diode ou un transistor ou un agencement de plusieurs transistors en série ou en parallèle.

3. Convertisseur de tension continu-continu selon l'une des revendications 1 ou 2, dans lequel le réservoir d'énergie électrique (C1) est un condensateur ou une batterie ou un supercondensateur.

4. Convertisseur de tension continu-continu selon l'une des revendications 1 à 3, dans lequel le circuit détecteur de crêtes principal (DC) est monté en parallèle avec l'élément interrupteur normalement bloqué (M1).

5. Convertisseur de tension continu-continu selon l'une des revendications 1 à 4, dans lequel l'élément interrupteur normalement passant (J1) est un transistor à enrichissement ou un transistor normalement bloqué commandé de manière à fonctionner comme un transistor normalement passant ou un limiteur de courant.

6. Convertisseur de tension continu-continu selon l'une des revendications 1 à 5, dans lequel l'élément interrupteur normalement bloqué (M1) est un MOSFET ou un IGBT ou un transistor bipolaire à jonction.

7. Convertisseur de tension continu-continu selon l'une des revendications 1 à 6, dans lequel le transformateur comporte au moins un enroulement secondaire (es2) aux bornes duquel un circuit de redressement (DC2) est branché.

8. Convertisseur de tension continu-continu selon l'une des revendications 1 à 7, dans lequel l'interrupteur principal (K) a une première extrémité (C) reliée à la charge (Z1) et une seconde extrémité (D) à relier à la source de tension continue (E), l'élément interrupteur normalement passant (J1) ayant une borne de commande reliée à la seconde extrémité (D) de l'interrupteur principal (K).

## Patentansprüche

1. DC/DC-Wandler, mit einem Hauptschalter (K), welcher aus einem Ausschaltelement (J1) in Reihe mit einem Einschaltelement (M1), das über einen Steuerstromkreis (G2) verfügt, besteht, wobei den beiden Schaltelementen (J1, M1) ein erster Knoten (A) gemein ist, einer Last (Z1) in Form eines Transformators mit einer Primärwicklung (ep) und mindestens einer Sekundärwicklung (es1, es2), wobei die Primärwicklung (ep) in Reihe mit dem Hauptschalter (K) geschaltet ist und der Hauptschalter und die Primärwicklung (ep) dafür vorgesehen sind, an den Anschlüssen einer Gleichspannungsquelle (E) angeordnet zu werden, und einem Haupt-Spitzenwert-Bewertungskreis (DC), dessen Eingang mit dem Hauptschalter und dessen Ausgang mit dem Steuerstromkreis (G2) des Einschaltelements (M1) verbunden ist, wobei der Haupt-Spitzenwert-Bewertungskreis (DC) einen unidirektionalen Stromschalter (D1) in Reihe mit einem Speicher für elektrische Energie (C1) umfasst, wobei der unidirektionale Stromschalter (D1) zwischen dem ersten Knoten (A) und dem Speicher für elektrische Energie (C) angeordnet ist und dafür vorgesehen ist, im geschlossenen Zustand den Speicher für elektrische Energie (C1) zu laden, wobei der Speicher für elektrische Energie (C1) eine Hauptnutzspannung (Vp) liefert, wenn der unidirektionale Stromschalter (D1) geöffnet ist, wobei die Hauptnutzspannung (Vp) an einem zweiten Knoten (B) zwischen dem Speicher für elektrische Energie (C1) und dem unidirektionalen Stromschalter (D1) abgegriffen wird, **dadurch gekennzeichnet, dass** dieser zweite Knoten (B) mit dem Eingang des Steuerstromkreises (G2) des Einschaltelements (M1) verbunden ist und dass der Haupt-Spitzenwert-Bewertungskreis (DC) ferner einen zusätzlichen unidirektionalen Stromschalter (Dj) umfasst, der zum einen mit dem zweiten Knoten (B) und zum anderen mit der Sekundärwicklung (es1) verbunden ist, wobei das Ausschaltelement (J1) über einen Steuerstromkreis (G1) verfügt, der mit einem Ende des Hauptschalters (K) verbunden ist, das an die Gleichspannungsquelle (E) anzuschließen ist.

2. DC/DC-Wandler gemäß Anspruch 1, bei dem die unidirektionale Stromeinrichtung (D1) eine Diode oder ein Transistor oder eine Anordnung mehrerer in Reihe oder parallel geschalteter Transistoren ist.

3. DC/DC-Wandler gemäß Anspruch 1 oder 2, bei dem der Speicher für elektrische Energie (C1) ein Kondensator oder eine Batterie oder ein Superkondensator ist.

4. DC/DC-Wandler gemäß einem der Ansprüche 1 bis 3, bei dem der Haupt-Spitzenwert-Bewertungskreis (DC) parallel zu dem Einschaltelement (M1) angeordnet ist.

5. DC/DC-Wandler gemäß einem der Ansprüche 1 bis 4, bei dem das Ausschaltelement (J1) ein Anreicherungstransistor oder ein Einschalttransistor, der so gesteuert wird, dass er wie ein Ausschalttransistor arbeitet, oder ein Strombegrenzer ist.

6. DC/DC-Wandler gemäß einem der Ansprüche 1 bis 5, bei dem das Einschaltelement (M1) ein MOSFET oder ein IGBT oder ein Sperrschichttransistor ist.

7. DC/DC-Wandler gemäß einem der Ansprüche 1 bis 6, bei dem der Transformator mindestens eine Sekundärwicklung (es2) umfasst, an deren Anschlüssen ein Gleichrichterkreis (DC2) angeschlossen ist.

8. DC/DC-Wandler gemäß einem der Ansprüche 1 bis 7, bei dem der Hauptschalter (K) ein erstes Ende (C) hat, das mit der Last (Z1) verbunden ist, und ein zweites Ende (D), das mit der Gleichspannungsquelle (E) zu verbinden ist, wobei das Ausschaltelement (J1) über einen Steueranschluss verfügt, der mit dem zweiten Ende (D) des Hauptschalters (K) verbunden ist.

## Claims

1. A DC-DC converter including a main switch (K) formed by a normally ON switch element (J1) connected in series with a normally OFF switch element (M1) equipped with a control circuit (G2), a first node (A) being common to both switch elements (J1, M1), a load (Z1) of the transformer type with a primary winding (ep) and at least one secondary winding (es1, es2), the primary winding (ep) being in series with the main switch (K), the main switch and the primary winding (ep) being intended to be connected to the terminals of a D-C voltage source (E), a main peak detector circuit (DC) connected at the input to the main switch and at the output to the control circuit (G2) of the normally OFF switch element (M1), wherein the main peak detector circuit (DC) includes a current unidirectional switch (D1) in series with an electrical energy reservoir (C1), the current unidirectional switch being connected between the first node (A) and the electrical energy reservoir (C), the current unidirectional switch (D1) being intended, when closed, to charge the electrical energy reservoir (C1), the electrical energy reservoir (C1) delivering a main useful voltage (Vp) when the current unidirectional switch is open (D1), the main useful voltage (Vp) being taken in at a second node (B) between the electrical energy reservoir (C1) and the current unidirectional switch (D1), **characterized in that** this second node (B) is connected to the input of the control circuit (G2) of the normally OFF switch element (M1), and **in that** the main peak detector circuit (DC) further includes a current unidirectional switch (Dj) connected on the one hand to the node (B) and on the other hand to the secondary winding (es1),
wherein the normally ON switch element (J1) is equipped with a control circuit (G1) connected at one end of the main switch (K) to be connected to the DC voltage source (E).

2. The DC-DC voltage converter according to claim 1, wherein the current unidirectional device (D1) is a diode or a transistor or an arrangement of several transistors in series or in parallel.

3. The DC-DC voltage converter according to one of claims 1 or 2, wherein the electrical energy reservoir (C1) is a capacitor or a battery or a supercapacitor.

4. The DC-DC voltage converter according to one of claims 1 to 3, wherein the main peak detector circuit (DC) is connected in parallel with the normally OFF switch element (M1).

5. The DC-DC voltage converter according to one of claims 1 to 4, wherein the normally ON switch element (J1) is an enhancement mode transistor or a normally OFF transistor controlled so as to operate as a normally ON transistor or a current limiter.

6. The DC-DC voltage converter according to one of claims 1 to 5, wherein the normally OFF switch element (M1) is a MOSFET or an IGBT or a bipolar junction transistor.

7. The DC-DC voltage converter according to one of claims 1 to 6, wherein the transformer includes at least one secondary winding (es2) at the terminals of which a rectifier circuit (DC2) is connected.

8. The DC-DC voltage converter according to one of claims 1 to 7, wherein the main switch (K) has a first end (C) connected to the load (Z1) and a second end (D) to be connected to the DC voltage source (E), the normally ON switch element (J1) having a control terminal connected to the second end (D) of the main switch (K).
